# EUROPEAN PATENT APPLICATION

(11) **EP 0 867 886 A2**
(43) Date of publication of application: **30.09.1998**
(21) Application number: 98302076.9
(22) Date of filing: 19.03.1998
(51) Int. Cl.: G11C 27/02

(54) **Floating point type analog register**

(30) Priority: 24.03.1997 JP 88955/97
(71) Applicant: G.D.S. CO., LTD., Minato-ku, Tokyo 107-0052 (JP); Nagazumi, Yasuo, Meguro-ku, Tokyo 153-0063 (JP)
(72) Inventor: Nagazumi, Yasuo, Tokyo, 153-0063 (JP)
(74) Representative: Rackham, Stephen Neil

(57) **Abstract**

A floating point type analog register is hereby proposed, wherein a concept of a floating point in a digital signal processing is expansively applied to detection of analog signals, and which makes it possible to directly convert the detected signals to floating point digital data by using an AD converter therewith.

The present device comprises: a gate means wherein an analog input signal is received and accumulated for a given period, and which is provided with a detecting means for detecting signal accumulated up to a given point of time, an input supply means for controlling the supply to said gate means of a given time-series and a time-series analog input signal in proportion to an input signal level, an input control means for evaluating by comparing with a given standard the signal of said gate means detected at a given timing and stopping the supply of analog input signals by controlling said input supply means, and a memory means for memorizing in digital an operation time point of said input control means.

## Description

### FIELD OF THE INVENTION

The present invention relates to a floating point type analog register which can be used for an analog signal detecting device, an imaging device, or the like.

### BACK GROUND OF THE INVENTION

In general, a signal level range effectively detectable by a sensor of analog signal is known as a dynamic range and is one of the important factors for estimating sensor performance. However, miniaturization of analog circuits and reduction of electric power consumption advanced in recent years, brought the trade-off problem between the dynamic range of analog/devices, making difficulties in circuit design.

Particularly, the imaging device, must often handle pixels having extremely wide luminance range and therefore it is strongly expected that a device with a wide dynamic range comes out so that an accurate video data can be obtained.

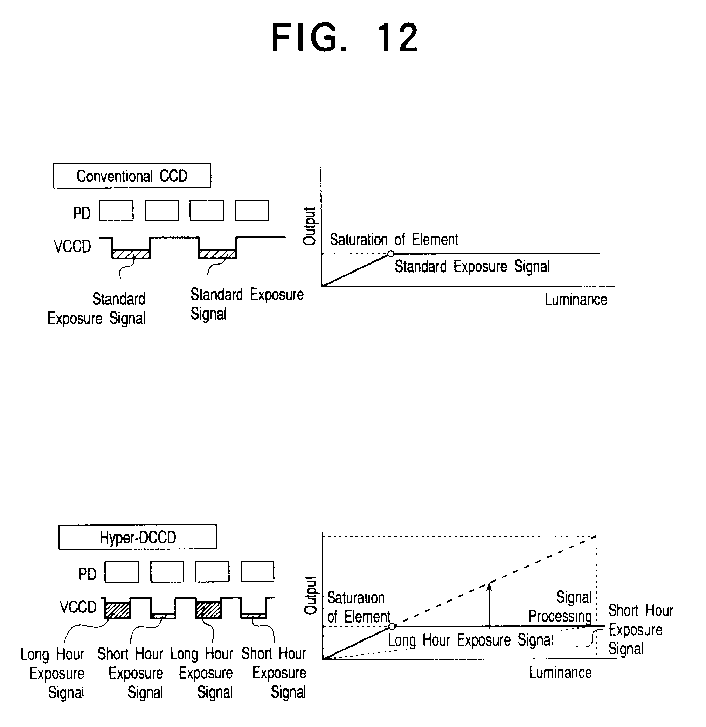

One of methods employed for this purpose, is multiple exposure time method depicted in the Fig.12 which extends dynamic range of each pixel data using plural data obtained under different exposure times. (referring to T.Kuroda et. al. "A 1/4 330K Square Pixel Progressive-Scan IT-CCD Image Sensor with Sub-Micrometer Channel Width" DIGEST OF TECHNICAL PAPERS, ISSCC96. Pp-184 - 185)

In this method, the number of output data for single frame increases corresponding to exposure times, requiring higher data transfer rate of CCD.

On the other hand, another method to improve dynamic range using logarithmic conversion, which converts each pixel data into logarithmic expression just after the detection of photons at each pixel location.

In this method, it is very difficult to reduce circuit size, because the accuracy of conversion strictly depends on the accuracy of circuit fabrication.
(referring to K. Takada et. al. "Logarithmic-Converting CCD line Sensor and Its Noise Characteristics" Proc. 1997 IEEE Workshop on CCD & AIS. PP(p6-1)-(p6-4))

On the other hand, in case of digital signal processing, floating point concept is widely adapted so far and it enables to handle data theoretically with nearly infinite dynamic range.

The present invention extensively adapts concept of floating point in a digital signal processing in order to detect an analog signal and discloses a method for extending a dynamic range of instrumentation different from the conventional method. Thus the present invention intends to propose a floating point type analog register device enable to have a constitution where a detected signal is directly converted to a floating point digital data by using AD converter in combination.

### SUMMARY OF THE INVENTION

The present invention is achieved in view of the above view point. The main constitution comprises a gate means W, receiving analog input signals and accumulating the signals for a given period, provided with a detecting means for detecting a signal accumulated up to a given point of time, an input supply means Z for controlling the supply a time-series analog input signal q(i) which is in proportion to an input signal Level L and a given time-series τ (i), to said gate means W, an input control means C for evaluating the signal of said gate means W detected at a given timing by comparing the signal with a given standard and stopping the supply of the analog input signal by controlling said input supply means Z, a memory means M for memorizing in digital an operation point of time of said input control means C , wherein the analog signal of said gate means W and a numerical value of said memory means M are output as one set of signals at a timing after the supply of analog input signal to said gate means W is stopped by the operation of said input supply means Z.

### BRIEF DESCRIPTION OF THE DRAWINGS

Fig.1 is an illustrative diagram, showing a basic constitution of the present invention according to one embodiment.

Fig.2 is a time chart, representing an operation of the embodiment as shown in Fig.1

Fig.3 is a diagram, showing an example wherein one concrete embodiment of the present invention is composed of a switched capacitor circuit.

Fig.4 is a signal chart, representing a control timing in the circuit as shown in Fig.3

Fig.5 is a diagram, showing a type of a constitution wherein the present invention is composed of CCD and a signal stored by an overflow of a charge is evaluated.

Fig.6 is a time chart, representing an operation of the embodiment as shown in Fig.5.

Fig.7 is a constitutional chart of an example, wherein the constitutions of the embodiment as shown in Fig.5 are disposed plurally and an output charge is applied to one-dimensional sensor as a form of transferring by CCD shift registers S, S".

Fig.8 is an illustrative diagram, showing a constitution of details of the construction as shown in Fig.7

Fig.9 is an illustrative diagram of one example of a constitution wherein an AD converter is further installed in the basic constitution of the embodiment as shown in Fig.5 and a floating point output is directly formed on a sensor chip.

Fig.10 is an illustrative diagram, further showing a constitution of other embodiment of the present invention.

Fig.11 is an illustrative diagram, further showing a constitution of other embodiment of the present invention.

Fig.12 is an illustrative diagram, showing a technique wherein video data successively obtained at two kinds of exposure times in a conventional example are output respectively and either one of those outputs is selected according to circumstances.

### PREFERRED EMBODIMENTS OF THE INVENTION

In the following, one embodiment of the present invention will be described with reference to the drawings attached hereto.

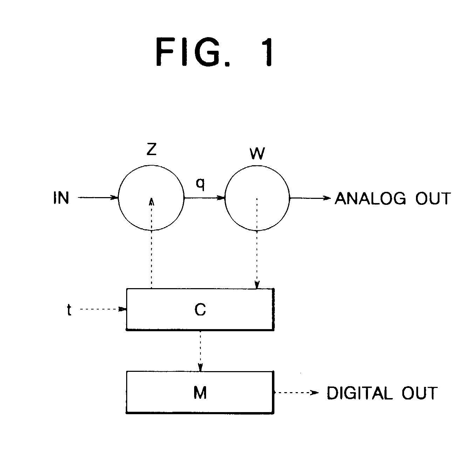

Fig.1 shows a basic constitution of the present invention.

Z as shown in the figure is an input supply means, which, to be concrete, comprises a switching mechanism of an input signal.

A gate means W integrates signal q which is supplied from said input supply means Z, and an input control means C watches the signal held by said gate means W at each given timing shown by t.

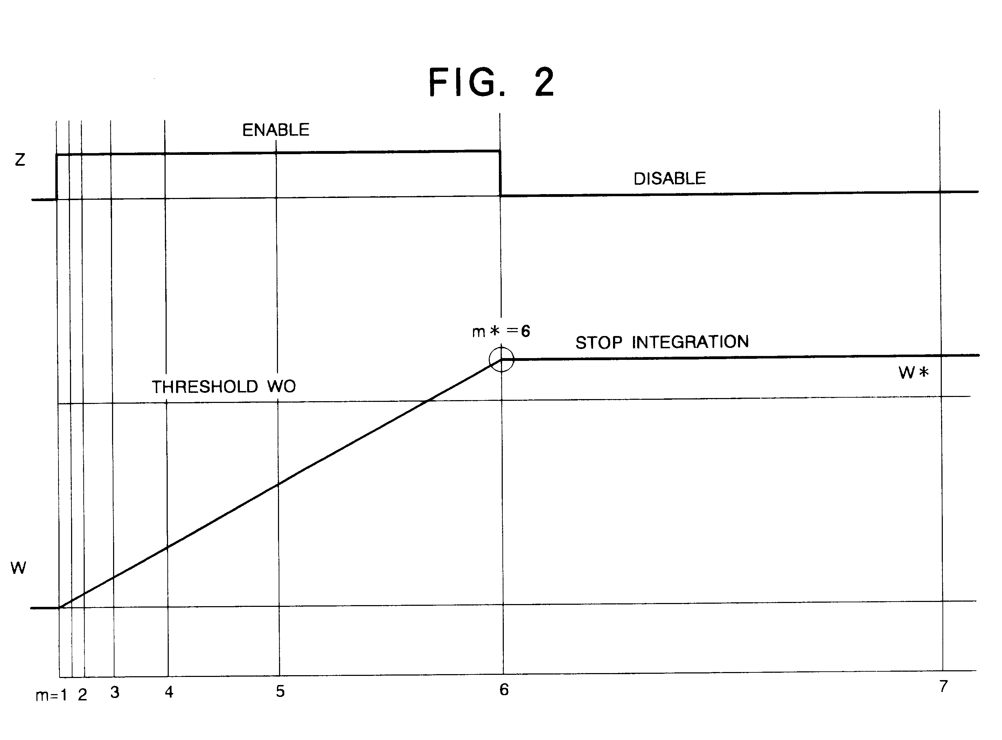

Fig.2 is a time chart, representing the operation of Fig.1 and the horizontal coordinate represents the time elapsed. m = 1 ∼ 7 as shown in the figure shows a typical example of the above watch timing.

In this case, the signal q which is supplied to gate means W shown in Fig. 1 is constant, thus the signal held by said gate means W (represented as signal W) increases monotonously as time elapses.

At this time, in case of the watch timing of a signal corresponding to m = 1 ∼ 5, since W is less than a given threshold volume(represented as WO), an input supply continues. While, in case of the timing m = 6 where W > WO, input control means C immediately stops the supply of the input signal to W.

As a result, on and after this point of time, an increase of W stops at the value of W∗.

Simultaneously, the point of time (m∗ = 6) where Z stops the supply of the input signal is memorized in digital memory means M and can be referred to from time to time.

Here, in the case that the point of time of m = 7 corresponds to the point of time where an output of the register is decided, the output is represented by two dimensional vectors (W∗, m∗) as expressed by two kinds of volumes of an analog volume W∗ and a digital volume m∗.

In the example as shown by the figure, since the axis of time is set at 2^{m}T with a time unit as T, the above output (W∗, m∗) means that the input signal q has a signal level to be integrated to the level of W∗ along a time integral 2^{m∗}T.

In other words, this is synonymous with q = W∗ · 2^{-m∗}/T.

In the above example, errors in the threshold value WO does not affect accuracy of the output signal in this constitution and a big advantage is that there scarcely arises any problem when a circuit is miniaturized.

For example, just because of difference in WO, even if there arise two kinds of cases in the operation timing of said input supply means Z where are case shows m*=5 and another case shows m*=6, a time of signal integration in the case of m*=6 is the twice of time in the case of m*=6, thus the value of W∗ also becomes twice of the case of m*=5. For example, in whichever case such as (1. 2, 5) or (2. 4, 6), the same output value can be basically expressed.

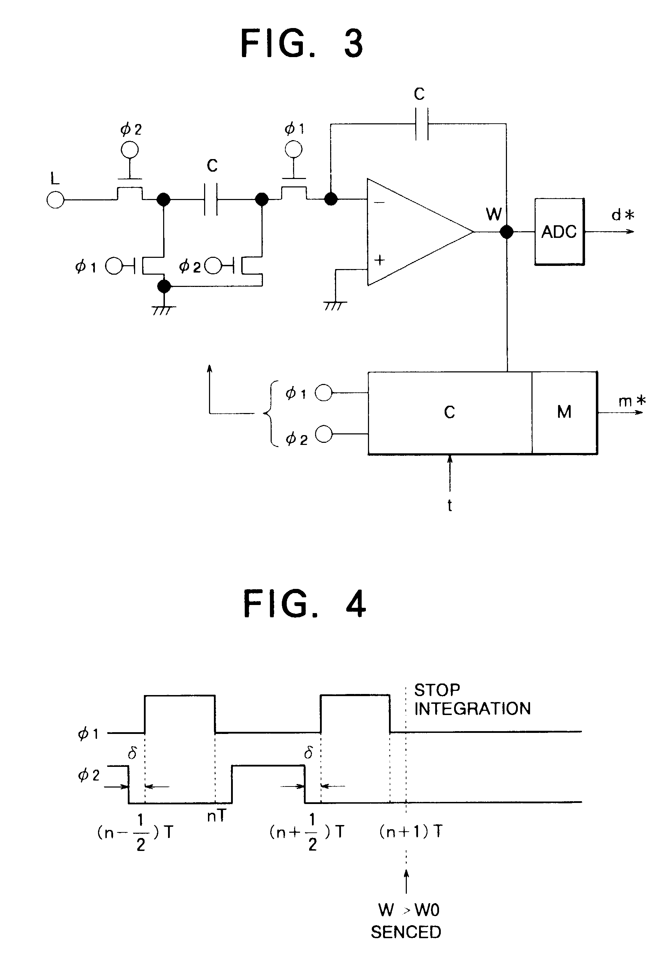

Fig.3 is an example wherein the present invention is constituted of a switched capacitor circuit.

Fig.4 shows the control timing. Two phase clocks (φ1, φ 2) supplied to SC circuit constituting an integrating device are supplied from the input supply control device. When the output W is sensed as W > WO at the watch timing of m = m∗, the clock supply to switched capacitor (SC) circuit is stopped from the time point shown by (N+1)T and an integration also stops.

This example shows a constitution wherein the analog output W is converted to a digital data d∗ by an AD converter and all of which comprises the floating point type AD converter.

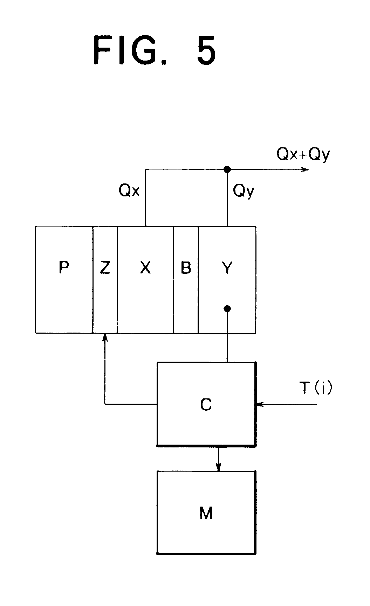

Fig.5 is a diagram, showing a type of a constitution wherein the present invention comprises CCD and evaluation of stored signal by the overflow of the charge is made.

In Fig.5, for example, a charge signal generating source P constituted with photo diode or the like supplies an input charge signal to a gate means X via an input supply means Z.

A first gate means X is connected with a second gate means Y via a potential barrier B. The charge signal supplied exceeding a charge capacity which the first gate means X is possible to store overflows from the barrier B and moves to the second gate means Y.

The constitution comprising the input supply means Z, the first gate means X, the potential barrier B and the second gate means Y is referred to as a fixed overflow gate and is one of the representative constitutions of multiple-valued logic circuit using a charge transfer element.
(refer to H. G .Kerkhoff et .al ."Multiple-valued Logic Charge-Coupled Devices" IEEE Trans. C-30, No.9, Sept. 1981)

On the other hand, the input supply means Z controls supply of the charge to the first gate means X from the charge generating source P by an input control means C.

The input control means C monitors the volume of charge signal stored by the second gate means Y at a given timing interval τ (i) and stops the supply of charge from charge generating source P as soon as it is evaluated that an overflow from the first gate means X to the second gate means Y is generated.

In the meantime, a digital memory means M attached to the input control means Counts the number of monitor timing interval τ (i) from start to end of detection, that is to say, the value of i and stores it as a digital data m.

Here, supposing that the monitor timing interval τ (i) is τ (i) = (1,1,2,4,8,16···), each monitor timing point of time after start of the detection becomes T(i) = (1,2,4,8,16,32) = 2ⁱ⁻¹ ···, Therefore, in the case where the charge signal generating source P supplies outputs at a constant electric current L, a total volume of the charge signal supplied from the charge signal generating source P by each monitor timing is in proportion to electric current L and T(i).

That is to say, supposing that a charge volume possible to store at the first gate means X is Qxmax, timing number i is stored to digital memory means M at the first timing at which the condition Qxmax < L · 2ⁱ⁻¹ is satisfied and at the same time the supply of input charge is stopped by operation of the input supply means Z. As a result, the charge volume Qx, Qy kept by the first and second gate means X,Y is kept as it is .

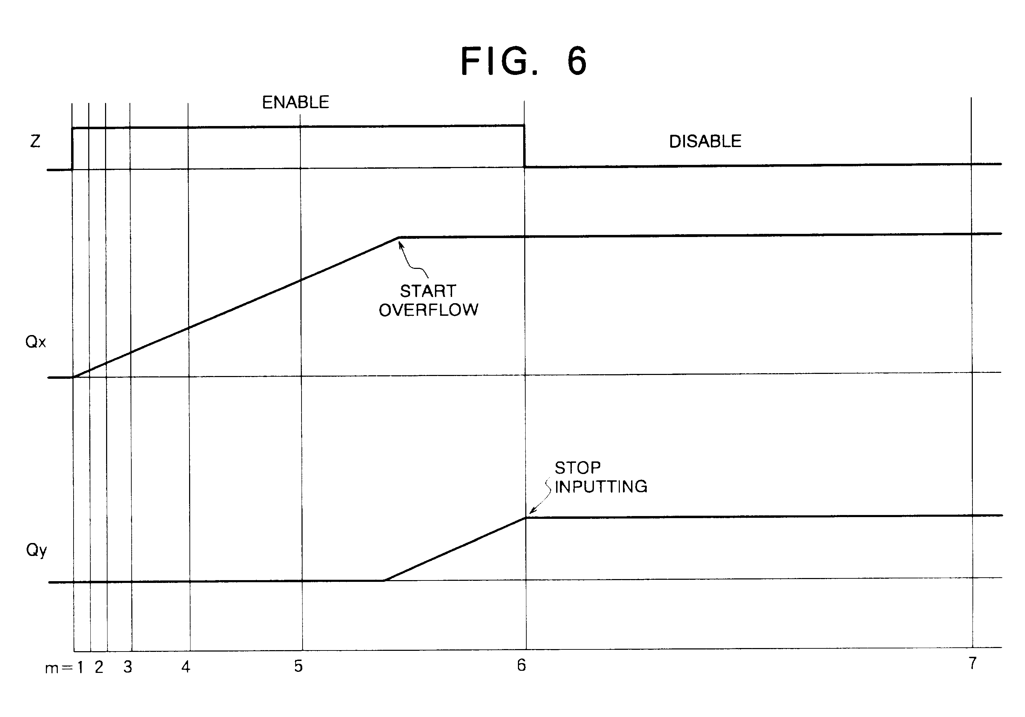

Fig.6 is a chart, showing the above example of operation in time series.

In Fig.6, a horizontal coordinate axis represents a time and a vertical lines shown by m = 1,2, ··· represents a check timing respectively. In the case of this example, since the first overflow from the first gate means X is detected by a timing of i = 6, the value of the digital memory means M is assigned to m=6 and at the same time the supply of a charge signal from P to the first and second gate means X and Y is prevented by the input signal supply means Z. Hence, the charge signal Qx + Qy becomes a constant value after becoming m = 6.

If Q = Qx + Qy, a value VL of the detected signal L is represented as VL = Q · 2^{1-m} which , it is clear, shows a floating point of an analog signal.

In another expression, it can be said as an analog signal accompanied with digital data m showing a binary range data.

As a matter of course, if Q is AD-converted, this expression becomes a floating point type digital numeric value as it is.

In the above case, Q is treated as Qx + Qy which is a sum of the charge stored in the first and second gate means X and Y. However, since the charge storage capacity of the first gate means X is constant, Qx becomes a constant value and for this reason an effective information is all included in Qy as long as the overflow is generated.

Accordingly, it is self-evident that an output charge signal of the device as shown in Fig.5 is basically sufficient to be Qy only.

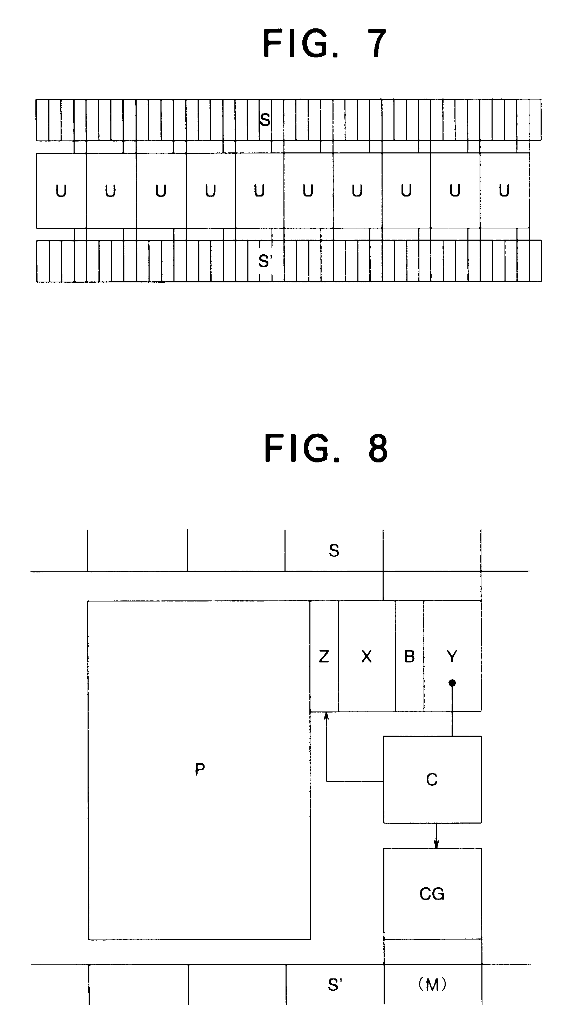

Fig.7 shows a constitution of the embodiment where the constitution of Fig.5 denoted by the symbol U is disposed plurally and the output charge signal is adapted to one dimensional photo sensor as a form of transferring the output charge signal via the CCD shift registers S and S'

In this example, a case is shown where a multi-valued shift register based on CCD is used as digital memory means M. However, it is only natural that this memory means is replaced by a digital shift register using an usual binary element. It is also naturally possible that this memory means is made into an output form using a data bus.

Fig.8 shows a detailed constitution example constituting that of Fig.7. In this example, a monitor timing T (i) is transmitted by a clock pulse supplied separately from the outside to the input control means C and by following this timing a volume of the charge existing in the second gate means Y is measured.

If the charge is not detected, an unit charge generating mechanism CG generates an unit charge, which is added to the digital memory means M.

Conversely, if the charge is detected, the adding operation is not performed and the supply of the charge from the charge signal generating source P is stopped by operation of the input control means C. At this point of time, measurement of the signal ends.

Transmission of the charge from the charge signal generating source P to the first gate means X may be allowed to be performed continuously from start to end of the measurement like the embodiment as shown in Fig.6 or to be performed intermittently at each point of time T (i). This form of transmission is a matter of designing and not a basic matter.

After the measurement ends, the charge signal stored in the second gate means Y is transferred to the shift register S and the charge stored in the digital memory means M is transferred to another shift register S' respectively and then outputted outside in order by shifting of S and S'.

The example of Fig.8 has a constitution wherein the digital memory means M is used in combination as a gate constituting shift register S'. Though not particularly shown in the drawing, similarly the first gate means X, the potential barrier B, a part or a whole of the second gate means Y can be used in combination as a gate constituting shift register S, because being constituted of the same CCD gate.

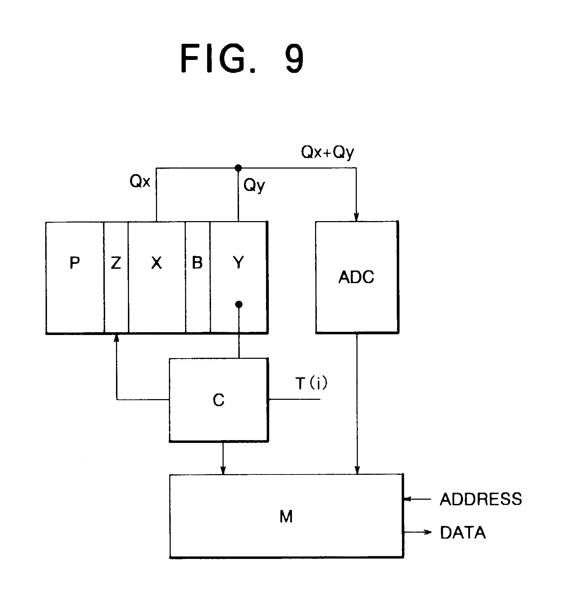

Fig.9 shows an embodiment wherein AD converter is attached to the constitution of Fig.5.and a floating point output is directly generated on a sensor chip.

This embodiment has a constitution, wherein a value of binary range data stored in a binary counter of an usual digital type built in the digital memory means M and the AD converter output data are output outside in parallel in bus form, and wherein each of the AD converter output and binary range data output are output outside by data bus at the time when selected by address bus.

Though not particularly shown in the drawing, it is only natural that two dimensional photo array can be formed by disposing embodiments of Fig. 7 plurally.

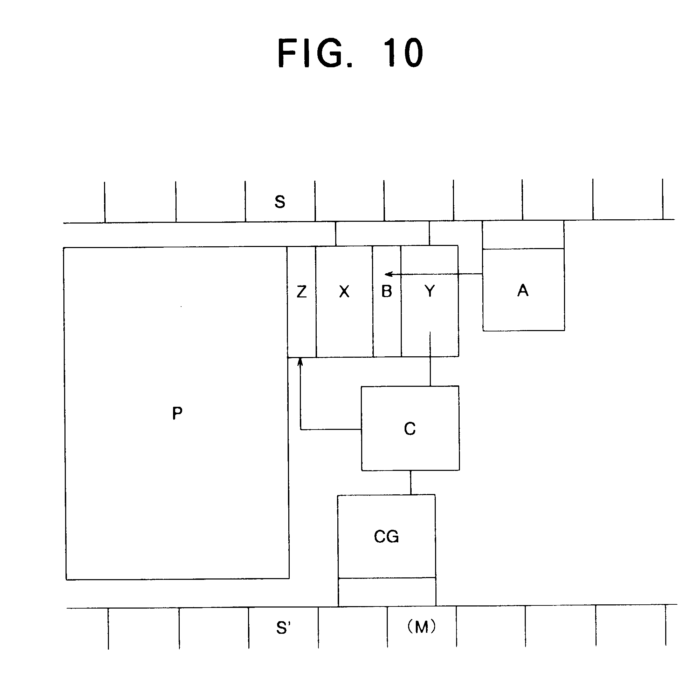

Fig.10 is an illustrative diagram, showing a constitution of other embodiment of the present invention.

In Fig.10, the potential barrier B which is one of the factors to decide the limit volume of the charge storage of the first gate means X has a constitution capable of making a level adjustment electrically by an adjustment device A.

In this embodiment, the adjustment device A is supplied with the charge signal for adjustment in advance at the initial stage of converting by the shift register S used for transferring an output signal and, according to this charge volume, a level of the potential barrier B is adjusted.

This constitution makes it possible to correct lack of uniformity accompanied with production of circuits after the production and is effective for maintaining the product quality.

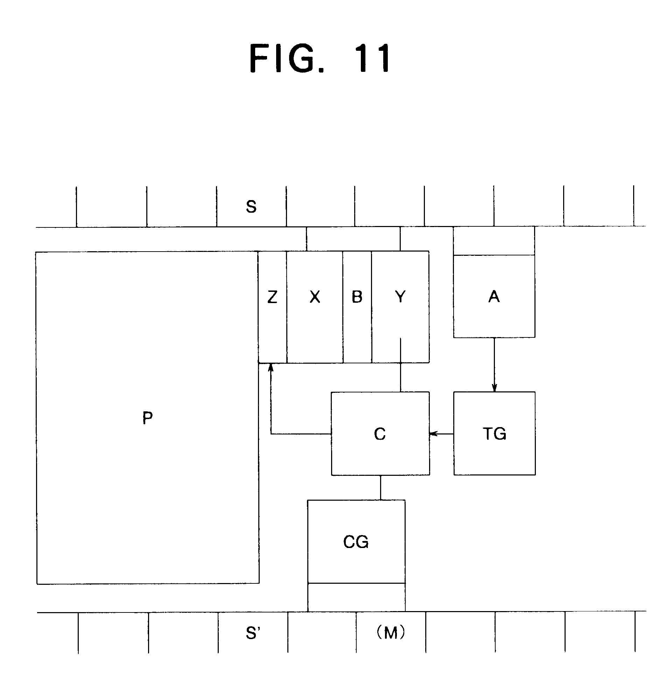

Fig.11 is an illustrative diagram, showing a constitution of other embodiment of the present invention. This embodiment is so constituted that a detecting timing of the overflow and timing generator TG generating a time series τ (i) for deciding a charge storage time are juxtaposed and since a basic time unit at the time when TG generates τ (i) is adjusted according to a signal from the adjustment device A, a charge supply volume from the charge generating source P is controlled by increase and decrease of an integration time.

If viewed from another point, this is equivalent to performing sensitivity adjustment of the charge generating source after producing the circuit.

Similar to the embodiment shown in Fig.10, this embodiment also makes it possible to correct lack of uniformity accompanied with production of the circuit after the production and is effective for maintaining the product quality.

In both embodiments as shown in Fig.10 and Fig.11, a case is shown, wherein an analog charge signal supplied via the shift register S is used as an input signal of the adjustment device A. As a matter of course, this adjustment signal is not restricted to the analog signal. For example, there is a form of memorizing a digital data for adjustment purpose supplied from bus line etc. with A as a digital memory.

As made quite clear from the above description, according to the present invention, it is now possible to indicate an analog data by a floating point format and extensively magnify a dynamic range of the data maintained. Further, by employing a photo sensor, an object having an extremely large luminance difference on the same picture frame can simultaneously be observed.

Also, digital data of the floating point mode are easily obtained by using the AD converter in combination and employed for improving processing accuracy of operation by using a digital processor, etc.

The entire disclosure of Japanese Patent Application No. 1997-88955 filed on March 24, 1997 including specification, claims, drawings and summary are incorporated here in by reference in its entirety.

## Claims

1. A floating point type analog register, comprising
a gate means W, receiving analog input signals and accumulating the signals for a given period, provided with a detecting means for detecting a signal accumulated up to a given point of time,
an input supply means Z for controlling the supply a time-series analog input signal q(i) which is in proportion to an input signal level L and a given time-series τ (i), to said gate means W,
an input control means C for evaluating the signal of said gate means W detected at a given timing by comparing the signal with a given standard and stopping the supply of the analog input signal by controlling said input supply means Z,
a memory means M for memorizing in digital an operation point of time of said input control means C ,
wherein the analog signal of said gate means W and a numerical value of said memory means M are output as one set of signals at a timing after the supply of analog input signal to said gate means W is stopped by the operation of said input supply means Z.

2. The floating point type analog register as claimed in Claim 1, wherein said gate means W is constituted of an analog integrating circuit comprising a switched capacitor, or the like.

3. The floating point type analog register as claimed in Claim 1, wherein said gate means W is constituted of a charge transfer element provided with a means for detecting a charge of a floating gate amp, or the like.

4. The floating point type analog register as claimed in Claim 1, wherein an output analog signal is not the signal itself as stored in said gate means W but an output of said signal detecting means attached to said gate means W.

5. The floating point type analog register as claimed in Claim 3, wherein said gate means W further comprises;
a first gate means X for receiving a charge input up to a given limit volume and making surplus charge exceeding the limit volume overflow, and
a second gate means Y receives the charge signal overflowed from said first gate means X and which has a charge detecting means for detecting presence or non-presence of the overflow, wherein the signal stored in said gate means W is evaluated by an inflow of the charge signal from said first gate means X to said second gate means Y,
and said input control means C evaluates generation of the overflow from said first gate means X and stops the supply of charge inputs via said input supply means Z.

6. The floating point type analog register as claimed in Claim 5, having a constitution wherein an electric potential of potential barrier B deciding the limit volume of a charge storage of said first gate means X is possible to be controlled, and wherein this electric potential is adjusted by a signal from the outside.

7. The floating point type analog register as claimed in Claim 5, further comprising a timing generator TG for generating the time series τ (i), wherein sensitivity adjustment is performed for an input level by increasing and decreasing an accumulation time of a charge by a signal from the outside.

8. The floating point type analog register as claimed in Claim 5, employing a multi-valued digital memory element as said memory means M.

9. The floating point type analog register as claimed in Claim 5, taking the analog output charge signal as a charge signal held by said second gate means Y.

10. The floating point type analog register as claimed in Claim 5, taking the analog output charge signal as a sum total of charge signals held by said first gate means X and said second gate means Y.

11. The floating point type analog register as claimed in any of Claim 1 to 10, employing monotonic increasing function such as τ (i) = (1, 1, 2, 4, 8, 16 ······) as said time-series τ (i).

12. A floating point type photo sensor, which has a constitution wherein the floating point type analog register as claimed in any of Claim1 to 11 is further juxtaposed with a photo electric converting element such as a photo diode.

13. A floating point type photo sensor array, which has a constitution wherein the floating point type photo sensor as claimed in Claim 12 is disposed one-dimensionally or two-dimensionally, and which is provided with an analog shift register S for transferring the charge signal generated by each photo sensor and stored in said gate means W.

14. A floating point type AD converter for converting an output analog signal into digital value to output, wherein an AD converting device is further attached to the floating point type analog register device as claimed in Claim 1 to 11.
